Europäisches Patentamt

European Patent Office

Office européen des brevets

(19)

(11) EP 1 169 651 B1

## (12) FASCICULE DE BREVET EUROPEEN

(45) Date de publication et mention
de la délivrance du brevet:
**30.06.2004 Bulletin 2004/27**

(21) Numéro de dépôt: **00918935.8**

(22) Date de dépôt: **11.04.2000**

(51) Int Cl.⁷: $G01R\ 33/12$, $G01R\ 27/26$

(86) Numéro de dépôt international:
**PCT/FR2000/000918**

(87) Numéro de publication internationale:
**WO 2000/063716 (26.10.2000 Gazette 2000/43)**

(54) **PROCEDE DE DETERMINATION DE LA PERMEABILITE D'UN MATERIAU MAGNETIQUE PAR PERTURBATION D'UNE LIGNE COAXIALE**

VERFAHREN ZUR BESTIMMUNG DER PERMEABILITÄT EINES MAGNETISCHEN MATERIALS DURCH DIE PERTURBATION EINES KOAXIALKABELS

METHOD FOR DETERMINING THE PERMEABILITY OF A MAGNETIC MATERIAL BY COAXIAL LINE PERTURBATION

(84) Etats contractants désignés:
**DE GB IT NL**

(30) Priorité: **15.04.1999 FR 9904726**

(43) Date de publication de la demande:
**09.01.2002 Bulletin 2002/02**

(73) Titulaire: **COMMISSARIAT A L'ENERGIE ATOMIQUE**
**75752 Paris Cédex 15 (FR)**

(72) Inventeurs:
• **ADENOT, Anne, Lise**
**F-37000 Tours (FR)**
• **ACHER, Olivier**
**F-37550 Saint Avertin (FR)**

(74) Mandataire: **Poulin, Gérard et al**
**Société BREVATOME**
**3, rue du Docteur Lancereaux**
**75008 Paris (FR)**

(56) Documents cités:
**FR-A- 2 699 683**

• **HENAUX J C ET AL: "DIMENSIONAL CORRECTION OF HIGH DIELECTRIC AND MAGNETIC CONSTANTS DETERMINED BY S PARAMETERS MEASUREMENTS" ELECTRONICS LETTERS,GB,IEE STEVENAGE, vol. 26, no. 15, 19 juillet 1990 (1990-07-19), pages 1151-1153, XP000107191 ISSN: 0013-5194**
• **ACHER O ET AL: "DEMONSTRATION OF ANISOTROPIC COMPOSITES WITH TUNEABLE MICROWAVE PERMEABILITY MANUFACTURED FROM FERROMAGNETIC THIN FILMS" IEEE TRANSACTIONS ON MICROWAVE THEORY AND TECHNIQUES,US,IEEE INC. NEW YORK, vol. 44, no. 5, 1 mai 1996 (1996-05-01), pages 674-684, XP000584875 ISSN: 0018-9480**
• **JACQUART P -M ET AL: "PERMEABILITY MEASUREMENT ON COMPOSITES MADE OF ORIENTED METALLIC WIRES FROM 0.1 TO 18 GHZ" IEEE TRANSACTIONS ON MICROWAVE THEORY AND TECHNIQUES,US,IEEE INC. NEW YORK, vol. 44, no. 11, 1 novembre 1996 (1996-11-01), pages 2116-2120, XP000632817 ISSN: 0018-9480**
• **ACHER O ET AL: "DIRECT MEASUREMENT OF PERMEABILITY UP TO 3 GHZ OF CO-BASED ALLOYS UNDER TENSILE STRESS" JOURNAL OF APPLIED PHYSICS,US,AMERICAN INSTITUTE OF PHYSICS. NEW YORK, vol. 73, no. 10 PT. 02B, 15 mai 1993 (1993-05-15), pages 6162-6164, XP000380460 ISSN: 0021-8979**

EP 1 169 651 B1

## Description

### Domaine technique

La présente invention a pour objet un procédé de détermination de la perméabilité d'un matériau magnétique par perturbation d'une ligne coaxiale. Elle trouve une application dans la caractérisation de matériaux, notamment de matériaux ferromagnétiques.

### Etat de la technique antérieure

Grâce à un analyseur de réseau, on peut mesurer la réflexion et la transmission d'une onde électromagnétique hyperfréquence sur et à travers un échantillon placé dans un guide d'onde. Dans le cas où ce guide est une ligne coaxiale, par exemple le standard APC7 dont la bande de fréquence va jusqu'à 18 GHz, on peut déduire de cette mesure la permittivité $\varepsilon$ et la perméabilité $\mu$ de l'échantillon par des équations dites de Nicholson et Weir [1, 2]. Ces équations ne s'appliquent qu'à un échantillon homogène massif isotrope, ce qui exclut donc de nombreux matériaux.

Si l'échantillon à caractériser est très conducteur, l'onde arrivant sur l'échantillon est totalement réfléchie, le coefficient de transmission est nul, et le signal réfléchi ne contient aucune information autre que le caractère très métallique de l'échantillon. Aussi, les couches minces métalliques, et en particulier les couches minces ferromagnétiques, ne peuvent-elles être caractérisées directement par cette méthode.

Des variantes utilisant d'autres types de guides ont été développées, mais pour les mêmes raisons, elles ne permettent pas de mesurer la perméabilité de couches minces ferromagnétiques.

Par ailleurs, des méthodes utilisant des guides rectangulaires ou des lignes microruban ont été mises au point pour des échantillons non métalliques mais anisotropes. Ces échantillons ne remplissent que partiellement le guide, car les dimensions des échantillons sont rédhibitoires (entre 350-500 MHz, les dimensions sont de 53,4 par 27,9 cm). Mais ces méthodes conduisent à des calculs numériques très lourds [3] en comparaison de la résolution des équations de Nicholson et Weir. De plus, la bande de fréquence de chaque guide est étroite ce qui nécessite de changer plusieurs fois de guide, donc de dimensions d'échantillon, pour couvrir une large bande de fréquence.

La méthode par perturbation de spire est une méthode de caractérisation simple des couches minces ferromagnétiques. Elle peut être considérée comme une ligne à microruban court-circuitée, ou se modéliser comme une spire carrée dont l'inductance est perturbée par la présence d'un échantillon magnétique. Cette méthode souffre de deux limitations majeures :

1°) la spire doit être étalonnée par la mesure d'un échantillon connu ; or, il n'existe pas d'étalon de perméabilité hyperfréquence, ni de moyen simple de raccordement à un étalon primaire ;

2) outre la limitation de sa bande de fréquence, un champ démagnétisant est introduit par la forme parallèlépipédique de l'échantillon [4] ; comme la dimension de l'échantillon est limitée dans la direction parallèle à l'excitation magnétique hyperfréquence, des pôles sont créés aux extrémités, ce qui modifie la perméabilité de l'échantillon par rapport à celle d'un échantillon plus grand. Plus le rapport entre la dimension parallèle à l'excitation et l'épaisseur est grand, plus cet effet est faible.

Or la limitation en dimension des spires est liée à leur caractère haute fréquence, et il n'est donc pas possible d'augmenter les dimensions sans réduire la bande de fréquence accessible.

Dans le cas de matériaux sous forme de fils, il est connu qu'en-deçà d'une certaine longueur, les propriétés magnétiques des fils changent considérablement. Il peut donc être très pénalisant de devoir se limiter, comme c'est le cas pour la mesure en spire, à des mesures sur des échantillons de petite longueur.

Le document FR-A-2 699 683 décrit un procédé de détermination de la perméabilité magnétique intrinsèque d'éléments ferromagnétiques allongés, dans lequel on réalise un tore bobiné avec les éléments ferromagnétiques, on dispose ce tore dans une ligne coaxiale, on effectue une mesure des propriétés du tore et on en déduit la perméabilité des éléments ferromagnétiques. Cette méthode présente l'avantage de ne pas nécessiter d'étalon de perméabilité. De plus, elle couvre une large bande de fréquence (de 50 MHz à 18 GHz). Enfin, la longueur de l'échantillon magnétique dans le sens de l'excitation magnétique hyperfréquence est grande, et l'on n'a pas à craindre d'effets démagnétisants.

Cependant, cette méthode présente des imperfections. En premier lieu, elle nécessite des quantités de matière beaucoup plus importantes que la mesure en spire : plusieurs dizaines de $mm^3$, contre un dixième de $mm^3$ ou moins pour les techniques en spire. Or, les moyens de réalisation des couches minces et des fils sont rarement compatibles avec la production de dizaines de $mm^3$ de matière. Dans les cas où la bonne quantité de matière est accessible, il est toutefois difficile d'être sûr de l'homogénéité des propriétés de l'ensemble de la matière utilisée pour réaliser l'échantillon.

En second lieu, le fait de bobiner le matériau souple à partir du diamètre intérieur de la ligne coaxiale conduit à donner un rayon de courbure très petit au matériau, de l'ordre de 1,5 mm pour une ligne APC7. Or, il est bien connu que plus le niveau de contrainte est élevé, plus on risque d'observer des effets magnétostrictifs, qui influent sur les propriétés du matériau. Le fait que la courbure varie beaucoup entre le diamètre intérieur et le diamètre extérieur de la ligne rend toute tentative de correction ou de prise en compte de cet effet illusoire.

Enfin, un dernier inconvénient de la mesure en tore bobiné est que la préparation de l'échantillon est longue et fastidieuse. Il faut préparer plusieurs mètres de ruban ferromagnétiques ou plusieurs centaines de mètres de fils. En pratique, la nécessité de cotes précises pour l'échantillon impose un usinage et l'utilisation de colle pour maintenir les nombreux tours de ruban, ce qui rajoute des contraintes mal maîtrisées. L'enlèvement de matière magnétique résultant de l'usinage produit une imprécision sur le taux de charge en matière magnétique, qui est répercutée sur la perméabilité du constituant ferromagnétique.

La présente invention a justement pour but de remédier à ces inconvénients.

### Exposé de l'invention

L'invention reprend l'idée d'une mesure dans une ligne coaxiale perturbée par l'échantillon, comme il est décrit dans FR-A-2 699 683, mais avec une fraction volumique d'échantillon beaucoup plus faible. Dans la présente invention, cette fraction (il s'agit du rapport entre le volume de l'échantillon et le volume de la partie de la ligne coaxiale où se trouve l'échantillon) est inférieure à 1%. Dans l'art antérieur, cette fraction est beaucoup plus importante (plusieurs dizaines de pourcents). Dans les exemples qui seront décrits plus loin, la fraction volumique tombe à 0,8% et même à 0,06%. Ces très faibles valeurs posent le problème de la détermination de la perméabilité en des termes nouveaux (les formules données dans le brevet cité ne sont plus valables). Par ailleurs, des précautions doivent être prises en constituant l'échantillon pour éviter ou réduire les champs démagnétisants.

De façon précise, l'invention a pour objet un procédé de détermination de la perméabilité d'un matériau magnétique par perturbation d'une ligne coaxiale hyperfréquence, dans lequel on constitue un échantillon dudit matériau, on place cet échantillon dans une ligne coaxiale hyperfréquence, on mesure la réflexion et/ou la transmission d'une onde électromagnétique hyperfréquence à travers cette ligne coaxiale et on déduit du résultat de cette mesure la perméabilité magnétique du matériau, ce procédé étant caractérisé en ce que la fraction volumique du matériau magnétique de l'échantillon par rapport au volume de la ligne coaxiale perturbée est inférieure à 1%.

Pour constituer l'échantillon, on peut soit bobiner un fil ou un ruban sur un support torique, par exemple isolant, soit déposer une couche mince sur un tel support. Pour obtenir le ruban, on peut déposer une couche mince du matériau magnétique sur un substrat souple et découper un ruban dans ce substrat selon une direction déterminée. La mesure de la perméabilité sera donc relative à cette direction. En changeant de direction, on peut explorer la perméabilité dans plusieurs directions.

Il est possible de fixer une extrémité du fil ou du ruban sur le support torique, d'exercer une tension sur ce fil ou ce ruban, puis de fixer la seconde extrémité du fil ou du ruban sur le support. On mesure ainsi la perméabilité sous contrainte, différente de celle sans contraintes à cause des effets magnétostrictifs.

On peut également former l'échantillon directement sur les conducteurs intérieur ou extérieur de la ligne coaxiale.

L'échantillon peut présenter une forme de tore complet ou seulement constituer un secteur torique.

Le matériau magnétique dont on mesure la perméabilité peut être quelconque et, notamment, être ferromagnétique.

### Brève description des dessins

- la figure 1 montre les variations de la perméabilité magnétique d'un fil en fonction de la fréquence, pour des mesures par perturbation de spire et par perturbation de ligne coaxiale,
- la figure 2 montre les variations de la perméabilité magnétique d'une couche mince ferromagnétique en fonction de la fréquence pour des mesures par perturbation de spire, par perturbation de ligne coaxiale et par tore bobiné.

### Exposé détaillé de modes particuliers de mise en oeuvre

Dans un premier mode de mise en oeuvre, la ligne coaxiale utilisée est le standard APC7. Le support torique isolant présente un diamètre intérieur égal à celui du conducteur central de la ligne soit A=2,94 mm ; le diamètre extérieur est de 5,94 mm, donc inférieur à celui du conducteur extérieur (B=7,1 mm). La hauteur H du tore est de 3 mm. L'exemple de matière magnétique choisi est un fil composite verre/ferromagnétique (composition du ferromagnétique : CoMnSiB) de diamètre $2R_{fil}$=150 $\mu$m. On enroule une longueur L=5,9 cm de fil sur le diamètre extérieur P du tore, soit 3 tours. Le support torique est en plexiglas. La fraction volumique de matériau est alors de 0,8 %.

La perméabilité $\mu_m$ d'un échantillon homogène dans une longueur de ligne d est calculée soit d'après une mesure en réflexion/transmission par les équations de Nicholson et Weir, soit devant un court-circuit. En effet, on peut se contenter de mesurer la réflexion de l'onde sur l'échantillon devant un court-circuit. L'impédance Z est calculée en fonction du taux de réflexion S à la fréquence f par la relation suivante (avec c vitesse de la lumière et j*j=-1) :

$$Z = \sqrt{\frac{\mu_m}{\varepsilon}}\tan(j\frac{2\pi}{c}fd\sqrt{\varepsilon\mu})_m \approx j\frac{2\pi}{c}fd\mu_m = \left(\frac{1-S}{1+S}\right)$$

On peut aussi introduire dans ce calcul la valeur de la permittivité ($\varepsilon$) (connue par une mesure en réflexion/transmission, par exemple) pour obtenir un calcul plus exact à haute fréquence.

On peut tenir compte de la contribution du support torique en plexiglas de la manière suivante. On considère que devant la longueur d'onde de travail (par exemple à 3 GHz, cette longueur d'onde est de 10 cm), les trois tours de fils forment une "bague" composite constituée d'air et de fil, d'épaisseur de diamètre du fil, de hauteur 3 mm. En magnétostatique, on montre que la perméabilité équivalente $\mu_{1+2}$ d'un ensemble formé par deux cylindres coaxiaux autour d'un fil parcouru par un courant de perméabilités respectives $\mu_1$ et $\mu_2$, de rayons interne et externe respectivement R0 et R1, R1 et R2 s'écrit :

$$\mu_{1+2}Ln\frac{R2}{R0} = \mu_1 Ln\frac{R1}{R0} + \mu_2 Ln\frac{R2}{R1}$$

Ceci permet d'éliminer la contribution du plexiglas ($\mu_1$=1) et de déterminer la perméabilité propre à la bague $\mu_2$=($\mu_{bague}$) , en choisissant $R_0$=A/2, $R_1$=P/2, $R_2$=B/2.

Si la bague extérieure était homogène, le calcul serait fini. C'est par une simple loi d'homogénéisation que l'on déduit maintenant la perméabilité $\mu_i$ de l'élément magnétique seul, de taux de charge q dans cette bague :

$$\mu_{bague} = q\mu_i + 1 - q$$

$$q = \frac{volume\ de\ fil}{volume\ de\ la\ bague} = \frac{R_{fil}^2 L}{((P + 2 * R_{fil})^2 - P^2)H}$$

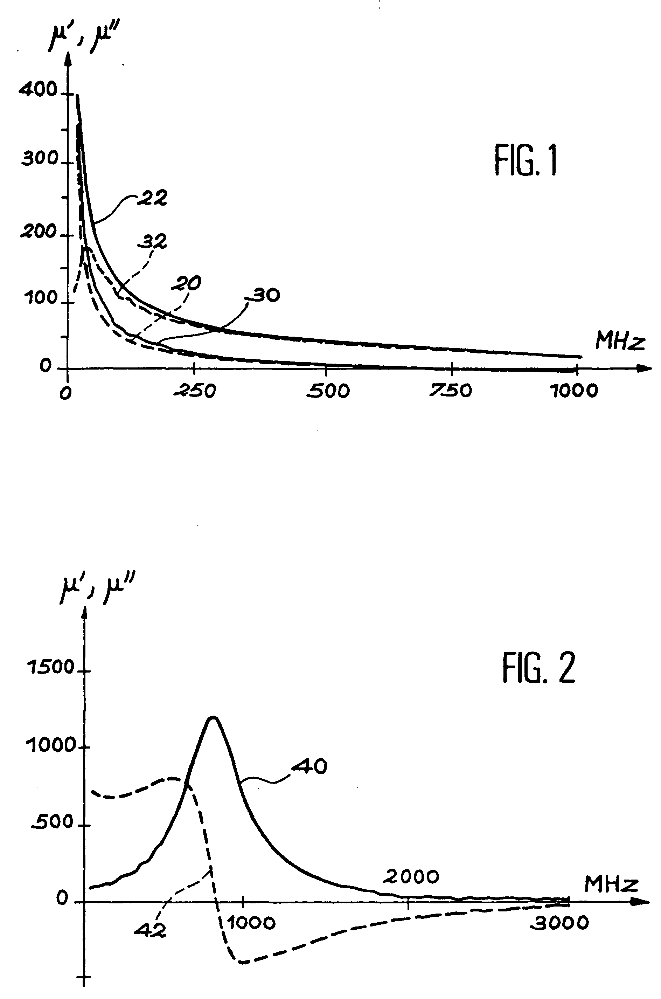

La figure 1 donne les résultats obtenus, pour la partie réelle $\mu'$ (courbe 20) et pour la partie imaginaire $\mu''$ (courbe 22) en fonction de la fréquence exprimée en MHz. La figure 1 donne également, pour comparaison, les résultats obtenus par la méthode de perturbation de spire (courbes 30, 32).

Dans un second mode de mise en oeuvre, la ligne coaxiale utilisée est le standard APC7. Le diamètre intérieur A du support torique, en plexiglas, est celui du conducteur intérieur : 2,94 mm ; le diamètre extérieur 2P est de 5,94 mm, donc inférieur à B, diamètre du conducteur extérieur (7,1 mm). La hauteur H du tore est de 3 mm. La matériau magnétique est une couche mince ferromagnétique de composition CoFeMoSiB d'épaisseur $e_{ferro}$ 0,227 μm sur substrat souple (kapton) d'épaisseur 12,7 μm. On mesure un ruban de 3 mm sur 90 mm, soit $n_{tours}$=4,75 tours. La fraction volumique de l'échantillon est de 0,06%.

Dans le cas de couches minces de faible épaisseur, sensibles aux effets magnétostrictifs, le sens d'enroulement face ferromagnétique à l'intérieur ou à l'extérieur crée des contraintes opposées qui font varier la fréquence de résonance de l'échantillon de façon symétrique autour de sa valeur à l'équilibre mécanique du film.

Pour comparer les méthodes de mesures, un tore bobiné de taux de charge de 13% a été constitué avec des rubans de même nature, mesuré en ligne APC7. On a effectué également des mesures par perturbation de spire.

La mesure par perturbation de ligne coaxiale nécessite 2,7 cm² de dépôt, ce qui est facilement accessible avec tous les moyens de dépôt, alors qu'un tore bobiné (technique antérieure) nécessite 600 cm² de dépôt.

Une méthode de calcul possible consiste à répéter la formule logarithmique autant de fois qu'il y a de couches, en considérant l'enroulement comme une suite de cylindres coaxiaux. Mais on peut aussi reprendre la démarche du premier exemple et rassembler les deux étapes en une seule, avec l'approximation P»$n_{tours}$ ($e_{ferro}$+$e_{substrat}$) , pour trouver très simplement la perméabilité $\mu_{ferro}$ en fonction de la perméabilité mesurée de $\mu_{mesuré}$ :

$$\mu_{ferro} - 1 \approx Ln\left(\frac{B}{A}\right)\frac{P}{e_{ferro}n_{tours}}(\mu_{mesuré} - 1)$$

La figure 2 illustre les résultats obtenus. La courbe 40 montre la partie réelle μ' et la courbe 42 la partie imaginaire μ". La comparaison avec la méthode de la spire ou la méthode du tore bobiné fait apparaître une très grande concordance entre les mesures (les courbes correspondantes sont quasiment confondues avec les courbes 40 et 42).

**Références**

1. "Measurement of the intrinsic properties of materials by time domain techniques", A.M. Nicholson and G.F. Ross, IEEE Trans. Instrum. Meas. **17** (1968), p.395.
2. "Automatic measurement of the complex dielectric constant and permeability at microwaves frequencies", W. W. Weir, Proc. IEEE **62** (1974), p.33.
3. "Mesure large bande de la perméabilité tensorielle des matériaux aimantés : problème inverse", P. Quéffélec et Ph. Gélin, Actes des 5e Journées Caractérisation Microondes et Matériaux, 13-15 mai 1998, document F7.
4. "Investigation of the gyromagnetic permeability of amorphous CoFeNiMoSiB manufactured by different techniques", O. Acher, C. Boscher, P. Le Guellec, Ph. Baclet and G. Perrin, IEEE Trans. Magn. **32** (1996), p.4833.

**Revendications**

**1.** Procédé de détermination de la perméabilité d'un matériau magnétique par perturbation d'une ligne coaxiale hyperfréquence, dans lequel on constitue un échantillon dudit matériau, on place cet échantillon dans une ligne coaxiale hyperfréquence, on mesure la réflexion et/ou la transmission d'une onde électromagnétique hyperfréquence sur et/ou à travers cette ligne coaxiale et on déduit du résultat de cette mesure la perméabilité magnétique du matériau, ce procédé étant **caractérisé en ce que** la fraction volumique du matériau magnétique de l'échantillon par rapport au volume de la ligne coaxiale perturbée est inférieure à 1%.

**2.** Procédé selon la revendication 1, dans lequel, pour constituer l'échantillon, on bobine un fil contenant le matériau magnétique à la surface d'un support torique.

**3.** Procédé selon la revendication 2, dans lequel on bobine quelques tours de fil sur le support torique.

**4.** Procédé selon la revendication 2, dans lequel le fil est un composite du matériau magnétique et d'un matériau isolant.

**5.** Procédé selon la revendication 2, dans lequel le support torique est isolant.

**6.** Procédé selon la revendication 1, dans lequel, pour constituer l'échantillon on dépose un ruban contenant le matériau magnétique sur la surface d'un support torique.

**7.** Procédé selon la revendication 6, dans lequel, pour obtenir le ruban on dépose une couche mince du matériau magnétique sur un substrat souple et on découpe un ruban dans ce substrat selon une direction déterminée.

**8.** Procédé selon la revendication 6, dans lequel le support torique est isolant.

**9.** Procédé selon l'une quelconque des revendications 2 ou 6, dans lequel on fixe une première extrémité du fil ou du ruban sur la surface du support torique, on exerce une tension sur le fil ou sur le ruban, puis on fixe la seconde extrémité du fil ou du ruban sur la surface du support torique, la perméabilité mesurée étant alors une perméabilité sous tension.

**10.** Procédé selon la revendication 1, dans lequel, pour constituer l'échantillon, on dépose une couche mince contenant le matériau magnétique sur la surface extérieure d'un support torique.

**11.** Procédé selon la revendication 10, dans lequel le support torique est isolant.

**12.** Procédé selon la revendication 1, dans lequel on place l'échantillon sur le conducteur intérieur ou extérieur de la ligne coaxiale.

**13.** Procédé selon la revendication 1, dans lequel on constitue un échantillon présentant la forme d'un secteur torique.

**14.** Procédé selon l'une quelconque des revendications 1 à 13, dans lequel le matériau magnétique est un matériau ferromagnétique.


**Patentansprüche**

**1.** Verfahren zur Bestimmung der Permeabilität eines magnetischen Materials durch die Störung einer Hyperfrequenz-Koaxialleitung, bei dem man ein Muster aus dem genannten Material bildet, dieses Muster in dieser Hyperfrequenz-Koaxialleitung anordnet, die Reflexion und/oder die Transmission einer elektromagnetischen Hyperfrequenzwelle auf bzw. in dieser Koaxialleitung und/oder durch diese Koaxialleitung hindurch misst und aus dem Resultat dieser Messung die magnetische Permeabilität des Materials ableitet,
**dadurch gekennzeichnet,**
**dass** der Volumenbruchteil des magnetischen Materials des Musters in Bezug auf das Volumen der gestörten Koaxialleitung kleiner als 1 % ist.

**2.** Verfahren nach Anspruch 1, bei dem man zur Bildung des Musters einen Draht bzw. Faden, der das magnetische Material enthält, auf die Oberfläche eines torischen Trägers aufspult.

**3.** Verfahren nach Anspruch 2, bei dem man einige Fadenwindungen auf den torischen Träger aufspult.

**4.** Verfahren nach Anspruch 2, bei dem der Faden ein Verbund des magnetischen Materials und eines isolierenden Materials ist.

**5.** Verfahren nach Anspruch 2, bei dem der torische Träger isolierend ist.

**6.** Verfahren nach Anspruch 1, bei dem man, um das Muster zu bilden, einen das magnetische Material enthaltenden Streifen auf der Oberfläche eines torischen Trägers anbringt.

**7.** Verfahren nach Anspruch 6, bei dem man, um den Streifen zu erhalten, eine dünne Schicht aus einem magnetischen Material auf einem flexiblen Substrat abscheidet und aus diesem Substrat einen Streifen herausschneidet, entsprechend einer bestimmten Richtung.

**8.** Verfahren nach Anspruch 6, bei dem der torische Träger isolierend ist.

**9.** Verfahren nach einem der Ansprüche 2 oder 6, bei dem man ein erstes Ende des Fadens oder des Streifens auf der Oberfläche des torischen Trägers befestigt, man eine Spannung ausübt auf den Faden oder den Streifen, dann das zweite Ende des Fadens oder des Streifens auf der Oberfläche des torischen Trägers befestigt, wobei die gemessene Permeabilität dann eine Permeabilität unter Spannung ist.

**10.** Verfahren nach Anspruch 1, bei dem man, um das Muster zu bilden, auf der Außenoberfläche eines torischen Trägers eine das magnetische Material enthaltende dünne Schicht aufbringt.

**11.** Verfahren nach Anspruch 10, bei dem der torische Träger isolierend ist.

**12.** Verfahren nach Anspruch 1, bei dem man das Muster auf dem inneren oder äußeren Leiter der Koaxialleitung anordnet.

**13.** Verfahren nach Anspruch 1, bei dem man ein Muster bildet, das die Form eines torischen Sektors aufweist.

**14.** Verfahren nach einem der Ansprüche 1 bis 13, bei dem das magnetische Material ein ferromagnetisches Material ist.

**Claims**

1. Process for determination of the permeability of a magnetic material by disturbance of a hyper frequency coaxial line, in which a sample of the said material is formed, this sample is placed in a hyper frequency coaxial line, the reflection and/or transmission of a hyper frequency electromagnetic wave on and/or through this coaxial line is measured and the result of this measurement is used to deduce the magnetic permeability of the material, this process being **characterized in that** the fractional volume of magnetic material in the sample compared with the volume of the disturbed coaxial line is less than 1%.

2. Process according to claim 1, in which a wire containing the magnetic material on the surface of a toric support is wound to form the sample.

3. Process according to claim 2, in which a few turns of wire are wound on the toric support.

4. Process according to claim 2, in which the wire is a composite of the magnetic material and an insulating material.

5. Process according to claim 2, in which the toric support is insulating.

6. Process according to claim 1, in which a ribbon containing the magnetic material is deposited on the surface of a toric support, in order to form the sample.

7. Process according to claim 6, in which a thin layer of a magnetic material is deposited on a flexible substrate to obtain the ribbon, and a ribbon is cut out of this substrate along a determined direction.

8. Process according to claim 6, in which the toric support is insulating.

9. Process according to any one of claims 2 or 6, in which a first end of the wire or ribbon is fixed on the surface of the toric support, tension is applied to the wire or the ribbon, and the second end of the wire or the ribbon is then fixed onto the surface of the toric support, the measured permeability then being a permeability under tension.

10. Process according to claim 1, in which the sample is created by depositing a thin layer containing the magnetic material on the outside surface of a toric support.

11. Process according to claim 10, in which the toric support is insulating.

12. Process according to claim 1, in which the sample is placed on the inside or outside conductor of the coaxial line.

13. Process according to claim 1, in which a sample is created in the form of a toric sector.

14. Process according to any one of claims 1 to 13, in which the magnetic material is a ferromagnetic material.

FIG. 1

FIG. 2